# EUROPEAN PATENT APPLICATION

(11) **EP 4 637 307 A1**
(43) Date of publication of application: **22.10.2025**
(21) Application number: 25168288.6
(22) Date of filing: 03.04.2025
(51) Int. Cl.: H10K 50/11, H10K 59/12, H10K 59/121

(54) **DISPLAY DEVICE AND METHOD OF FABRICATING THE SAME**

(30) Priority: 17.04.2024 KR 20240051297
(71) Applicant: Samsung Display Co., Ltd., Yongin-si, Gyeonggi-do 17113 (KR)
(72) Inventor: SHIN, Hyun Eok, 17113 Giheung-gu, Yongin-si, Gyeonggi-do (KR); MOON, Young Min, 17113 Giheung-gu, Yongin-si, Gyeonggi-do (KR); SO, Byung Soo, 17113 Giheung-gu, Yongin-si, Gyeonggi-do (KR); LEE, Chang Hee, 17113 Giheung-gu, Yongin-si, Gyeonggi-do (KR); JANG, Keun Ho, 17113 Giheung-gu, Yongin-si, Gyeonggi-do (KR); SONG, Seung Yong, 17113 Giheung-gu, Yongin-si, Gyeonggi-do (KR)
(74) Representative: Dr. Weitzel & Partner

(57) **Abstract**

A display device includes a substrate, a pixel circuit layer above the substrate, a first anode, a second anode, and a third anode spaced apart above the pixel circuit layer, a pixel-defining layer above the pixel circuit layer, and overlapping portions of the first anode, the second anode, and the third anode, a first emission structure, a second emission structure, and a third emission structure respectively above the first anode, the second anode, and the third anode, and respectively including curved edges, and a common layer above the first emission structure, the second emission structure, the third emission structure, and the pixel-defining layer.

## Description

### BACKGROUND

### 1. Field

Aspects of some embodiments of the present invention relate to a display device, and a method of fabricating the display device.

### 2. Description of the Related Art

With the development of information technology, the importance of a display device, which is a connection medium between a user and information, has been emphasized. Owing to the importance of display devices, the use of various kinds of display devices, such as a liquid crystal display device and an organic light-emitting display device, has increased.

The above information disclosed in this Background section is only for enhancement of understanding of the background, and therefore the information discussed in this Background section does not necessarily constitute prior art.

### SUMMARY

The invention is defined by the independent claims. Aspects of some embodiments of the present invention include a method of fabricating a display device through an indirect patterning process, and a display device fabricated by the method.

According to a first aspect of the present invention, a display device includes a substrate, a pixel circuit layer above the substrate, a first anode, a second anode, and a third anode spaced apart above the pixel circuit layer, a pixel-defining layer above the pixel circuit layer, and overlapping portions of the first anode, the second anode, and the third anode, a first emission structure, a second emission structure, and a third emission structure respectively above the first anode, the second anode, and the third anode, and respectively including curved edges, and a common layer above the first emission structure, the second emission structure, the third emission structure, and the pixel-defining layer.

In particular, the first anode, the second anode, and the third anode are spaced apart from each other and located above the pixel circuit layer.

The edges of the first emission structure, the second emission structure, and the third emission structure may have a slope on the pixel-defining layer.

The first emission structure, the second emission structure, and the third emission structure may have an inverted tapered shape.

Widths of the first emission structure, the second emission structure, and the third emission structure may increase in a thickness direction.

The first emission structure, the second emission structure, and the third emission structure may include a hole injection layer, a hole transport layer above the hole injection layer, an emission layer above the hole transport layer, and a buffer layer above the emission layer.

The common layer may include an electron transport layer above the first emission structure, the second emission structure, the third emission structure, and the pixel-defining layer, an electron injection layer above the electron transport layer, and a cathode above the electron injection layer.

The common layer may further include an auxiliary electrode above the cathode.

The cathode and the auxiliary electrode may include different materials.

The cathode may include a translucent conductive material, wherein the auxiliary electrode includes a transparent conductive material.

The first emission structure, the second emission structure, and the third emission structure may include a hole injection layer, a hole transport layer above the hole injection layer, an buffer layer buffer layer

above the hole transport layer, a buffer layer above the emission layer, an electron transport layer above the buffer layer, and an electron injection layer above the electron transport layer.

The common layer may include a cathode above the first emission structure, the second emission structure, the third emission structure, and the pixel-defining layer.

The display device may further include an encapsulation layer above the common layer.

According to a further aspect of the present invention, a method of fabricating a display device includes forming a first anode, a second anode, a third anode, and a pixel-defining layer above a pixel circuit layer above a substrate, forming a cover layer above a portion of the pixel-defining layer, forming a first emission structure above the first anode, the second anode, the third anode, the pixel-defining layer, and the cover layer, forming a first sacrificial layer above the first emission structure, forming a first photoresist above a portion of the first sacrificial layer, removing the first emission structure and the first sacrificial layer above the second anode, the third anode, and the cover layer, and removing the first photoresist.

The cover layer may include a first layer having a first thickness, and a second layer above the first layer, and having a second thickness that is less than the first thickness.

A width of the second layer may be greater than a width of the first layer.

The second layer may overlap edges of the first anode, the second anode, and the third anode.

The method may further include forming a second emission structure above the first sacrificial layer, the second anode, the third anode, the pixel-defining layer, and the cover layer, forming a second sacrificial layer above the second emission structure, forming a second photoresist above a portion of the second sacrificial layer, removing the second emission structure and the second sacrificial layer above the first sacrificial layer, the third anode, and the cover layer, and removing the second photoresist.

The method may further include forming a third emission structure above the first sacrificial layer, the second sacrificial layer, the third anode, the pixel-defining layer, and the cover layer, forming a third sacrificial layer above the third emission structure, forming a third photoresist above a portion of the third sacrificial layer, removing the third emission structure and the third sacrificial layer above the first sacrificial layer, the second sacrificial layer, and the cover layer, and removing the third photoresist.

The method may further include removing the first to the third sacrificial layers and the cover layer.

The method may further include forming a common layer above the first emission structure, the second emission structure, the third emission structure, and the pixel-defining layer, and forming an encapsulation layer above the common layer.

### BRIEF DESCRIPTION OF DRAWINGS

The above and other aspects of embodiments according to the present invention will become more apparent by describing, in further detail, aspects of some embodiments thereof with reference to the accompanying drawings, in which:
FIG. 1 is a block diagram illustrating a display device in accordance with one or more embodiments.
FIG. 2 is a block diagram illustrating a sub-pixel in accordance with one or more embodiments.
FIG. 3 is a plan view illustrating a display panel in accordance with one or more embodiments.
FIG. 4 is a sectional view illustrating a display panel in accordance with one or more embodiments.
FIG. 5 is a sectional view illustrating a display panel in accordance with one or more embodiments.
FIG. 6 is a plan view illustrating a pixel in accordance with one or more embodiments.
FIG. 7 is a sectional view taken along the line I-I' of FIG. 6 in accordance with one or more embodiments.
FIG. 8 is a sectional view taken along the line I-I' of FIG. 6 in accordance with one or more embodiments.
FIG. 9 is a sectional view taken along the line I-I' of FIG. 6 in accordance with one or more embodiments.
FIG. 10 is a flowchart illustrating a method of fabricating the display device in accordance with one or more embodiments.
FIGS. 11 to 27 are sectional views schematically illustrating the method of fabricating the display device in accordance with embodiments.
FIG. 28 is a block diagram illustrating a display system in accordance with one or more embodiments.
FIGS. 29 to 32 are perspective views illustrating application examples of the display system of FIG. 28.

### DETAILED DESCRIPTION

Aspects of some embodiments of the present invention and methods of accomplishing the same may be understood more readily by reference to the detailed description of embodiments and the accompanying drawings. The described embodiments are provided as examples so that this invention will be thorough and complete, and will fully convey the aspects of the present invention to those skilled in the art. Accordingly, processes, elements, and techniques that are redundant, that are unrelated or irrelevant to the description of the embodiments, or that are not necessary to those having ordinary skill in the art for a complete understanding of the aspects of the present invention may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present invention.

A person of ordinary skill in the art would appreciate, in view of the present invention in its entirety, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the invention is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this invention, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present invention. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present invention. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present invention. In addition, in some embodiments, the block, unit and/or module may be physically combined into more complex blocks, units, and/or modules without departing from the scope of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

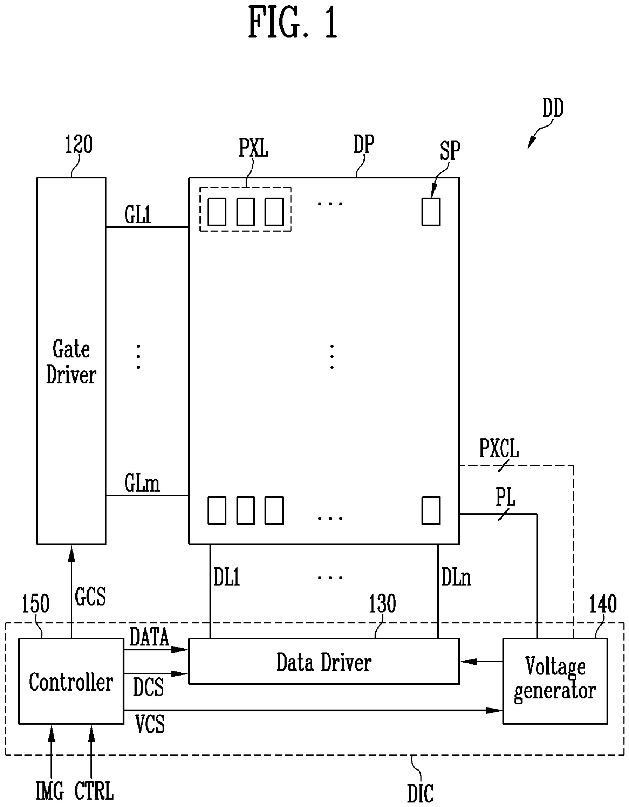

FIG. 1 is a block diagram illustrating a display device in accordance with one or more embodiments.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light in two or more colors. For example, each of the sub-pixels SP may generate light in a color, such as red, green, blue, cyan, magenta, or yellow.

Two or more sub-pixels among the sub-pixels SP may form one pixel PXL. For example, the pixel PXL may include three sub-pixels, as illustrated in FIG. 1. As such, the pixel PXL may emit light of various colors and various luminances depending on the combination of light emitted from the sub-pixels included therein.

The gate driver 120 may be connected to sub-pixels SP arranged in a row direction through first to m-th gate lines GL1 to GLm. The gate driver 120 may output gate signals to the first to m-th gate lines GL1 to GLm in response to a gate control signal GCS. In embodiments, the gate control signal GCS may include a start signal instructing each frame to start, a horizontal synchronization signal, and the like.

The gate driver 120 may be located on one side of the display panel DP. However, the embodiments are not limited to the aforementioned example. For example, the gate driver 120 may be divided into two or more drivers that are physically and/or logically distinguished from each other. The drivers may be located on a first side of the display panel DP and a second side of the display panel DP opposite to the first side. As such, the gate driver 120 may be located around the display panel DP in various forms depending on the embodiments.

The data driver 130 may be connected to sub-pixels SP arranged in a column direction through the first to n-th data lines DL1 to DLn. The data driver 130 may receive image data DATA and a data control signal DCS from the controller 150. The data driver 130 may operate in response to the data control signal DCS. In embodiments, the data control signal DCS may include a source start signal, a source shift clock, a source output enable signal, and the like.

The data driver 130 may receive voltages from the voltage generator 140. The data driver 130 may apply, using received voltages, data signals having grayscale voltages corresponding to the image data DATA to the first to n-th data lines DL1 to DLn. When a gate signal is applied to each of the first to m-th gate lines GL1 to GLm, data signals corresponding to the image data DATA may be applied to the first to n-th data lines DL1 to DLn. Hence, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS provided from the controller 150. The voltage generator 140 is configured to generate a plurality of voltages, and to provide the generated voltages to components of the display device DD, such as the gate driver 120, the data driver 130, and the controller 150. The voltage generator 140 may receive an input voltage from an external device of the display device DD, and may generate a plurality of voltages by regulating the received voltage.

The voltage generator 140 may generate a first power voltage and a second power voltage. The generated first and second power voltages may be provided to the sub-pixels SP through power lines PL. In other embodiments, at least one of the first or second power voltages may be provided from an external device to the display device DD.

In addition, the voltage generator 140 may provide various voltages and/or signals. For example, the voltage generator 140 may provide one or more initialization voltages to be applied to the sub-pixels SP. For example, during a sensing operation for sensing electrical characteristics of transistors and/or light-emitting elements of the sub-pixels SP, a certain reference voltage may be applied to each of the first to n-th data lines DL1 to DLn. The voltage generator 140 may generate the reference voltage, and may transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide pixel control signals to the sub-pixels SP through pixel control lines PXCL. Although in FIG. 1 there is illustrated the case where the pixel control lines PXCL are connected between the voltage generator 140 and the display panel DP, the embodiments are not limited thereto. For example, the pixel control lines PXCL may be connected between the gate driver 120 and the display panel DP. In this case, the pixel control signals may be transmitted from the voltage generator 140 to the pixel control lines PXCL through the gate driver 120.

The controller 150 may control overall operations of the display device DD. The controller 150 may receive input image data IMG and a control signal CTRL corresponding thereto from an external device. The controller 150 may provide a gate control signal GCS, a data control signal DCS, and a voltage control signal VCS, in response to the control signal CTRL.

The controller 150 may convert the input image data IMG to be suitable for the display device DD or the display panel DP, and then may output image data DATA. In embodiments, the controller 150 may align the input image data IMG to be suitable for the sub-pixels SP on a row basis and then output the image data DATA.

Two or more components of the data driver 130, the voltage generator 140, and the controller 150 may be mounted on a single integrated circuit. As illustrated in FIG. 1, the data driver 130, the voltage generator 140, and the controller 150 may be included in a driver integrated circuit DIC. In this case, the data driver 130, the voltage generator 140, and the controller 150 may be components that are functionally separated from each other in the single driver integrated circuit DIC. In other embodiments, at least one of the data driver 130, the voltage generator 140, or the controller 150 may be provided as a component separated from the driver integrated circuit DIC.

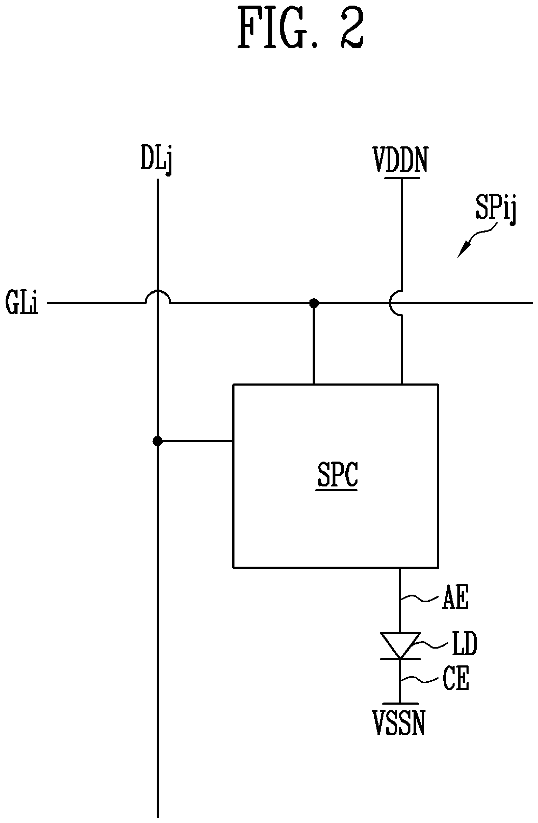

FIG. 2 is a block diagram illustrating a sub-pixel in accordance with one or more embodiments. In FIG. 2, there is illustrated a sub-pixel SPij located on an i-th row (where i is an integer identical to or greater than 1 and identical to or less than m) and a j-th column (where j is an integer identical to or greater than 1 and identical to or less than n) among the sub-pixels SP of FIG. 1.

Referring to FIG. 2, the sub-pixel SPij may include a sub-pixel circuit SPC and a light-emitting element LD.

The light-emitting element LD is connected between a first power voltage node VDDN and a second power voltage node VSSN. The first power voltage node VDDN may be connected to one of the power lines PL of FIG. 1 to receive a first power voltage. The second power voltage node VSSN may be connected to another one of the power lines PL of FIG. 1 to receive a second power voltage. The first power voltage may have a voltage level that is higher than the second power voltage.

The light-emitting element LD may be connected between an anode electrode AE and a cathode electrode CE. The anode AE may be connected to the first power voltage node VDDN through the sub-pixel circuit SPC. For example, the anode AE may be connected to the first power voltage node VDDN through one or more transistors included in the sub-pixel circuit SPC. The cathode CE may be connected to the second power voltage node VSSN. The light-emitting element LD is configured to emit light based on current flowing from the anode AE to the cathode CE.

The sub-pixel circuit SPC may be connected both to an i-gate line GLi among the first to m-th gate lines GL1 to GLm of FIG. 1 and to a j-th data line DLj among the first to n-th data lines DL1 to DLn of FIG. 1. In response to a gate signal received through the i-th gate line GLi, the sub-pixel circuit SPC may control the light-emitting element LD to emit light based on a data signal received through the j-th data line DLj. In embodiments, the sub-pixel circuit SPC may be further connected to the pixel control lines PXCL of FIG. 1. In this case, the sub-pixel circuit SPC may further control the light-emitting element LD in response to pixel control signals received through the pixel control lines PXCL.

For the sake of the aforementioned operations, the sub-pixel circuit SPC may include circuit elements, for example, transistors and one or more capacitors.

The transistors of the sub-pixel circuit SPC may include P-type transistors and/or N-type transistors. In embodiments, the transistors of the sub-pixel circuit SPC may include a metal oxide silicon field effect transistor (MOSFET). In embodiments, the transistors of the sub-pixel circuit SPC may include an amorphous silicon semiconductor, a monocrystalline silicon semiconductor, a polycrystalline silicon semiconductor, an oxide semiconductor, or the like.

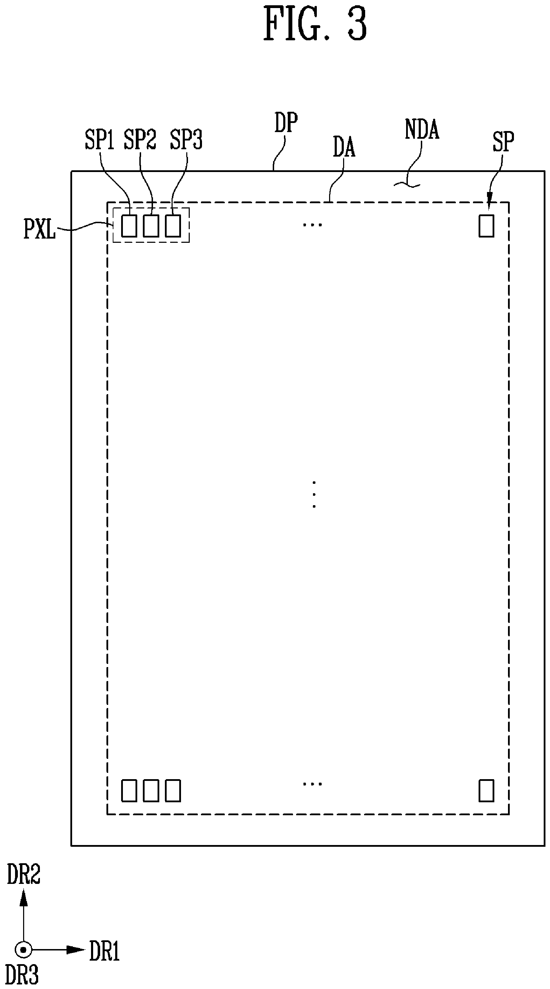

FIG. 3 is a plan view illustrating the display panel DP in accordance with one or more embodiments.

Referring to FIG. 3, the display panel DP may include a display area DA and a non-display area NDA. The display panel DP may display an image through the display area DA. The non-display area NDA may be located around the display area DA.

The display panel DP includes sub-pixels SP in the display area DA. The sub-pixels SP may be arranged in a first direction DR1, and in a second direction DR2 crossing the first direction DR1. For example, the sub-pixels SP may be arranged in the form of a matrix in the first direction DR1 and in the second direction DR2. As another example, the sub-pixels SP may be arranged in a zigzag form in the first direction DR1 and the second direction DR2. The arrangement of the sub-pixels SP may be changed depending on embodiments. The first direction DR1 may refer to a row direction, and the second direction DR2 may refer to a column direction.

Two or more sub-pixels among the sub-pixels SP may form one pixel PXL. Although FIG. 3 illustrates that the pixel PXL includes three sub-pixels SP1 to SP3, the embodiments are not limited thereto. For example, the pixel PXL may include two sub-pixels. Hereinafter, for convenience of explanation, it is assumed that the pixel PXL includes first to third sub-pixels SP1 to SP3.

Each of the first to third sub-pixels SP1 to SP3 may generate light of one among various colors, such as red, green, blue, cyan, magenta, and yellow. Hereinafter, for clear and concise description, it is assumed that the first sub-pixel SP1 is configured to generate light in red, the second color pixel SP2 is configured to generate light in green, and the third sub-pixel SP3 is configured to generate light in blue.

Each of the first to third sub-pixels SP1 to SP3 may include at least one light-emitting element configured to generate light. In embodiments, the light-emitting elements of the first to third sub-pixels SP1 to SP3 may generate light in the same color. For example, the light-emitting elements of the first to third sub-pixels SP1 to SP3 may generate light in blue. In other embodiments, the light-emitting elements of the first to third sub-pixels SP1 to SP3 may generate light in different colors. For example, the light-emitting elements of the first to third sub-pixels SP1 to SP3 may respectively generate light in red, green, and blue.

As a display panel DP, a self-luminous display panel, such as an LED display panel using a micro-scale or nano-scale light-emitting diode as a light-emitting element, and an organic light-emitting display panel (OLED panel) using an organic light-emitting diode as a light-emitting element may be used.

Components for controlling the sub-pixels SP may be located in the non-display area NDA. Lines connected to the sub-pixels SP, for example, the first to m-th gate lines GL1 to GLm, the first to n-th data lines DL1 to DLn, the power lines PL, and the pixel control lines PXCL of FIG. 1, may be located in the non-display area NDA.

At least one of the gate driver 120, the data driver 130, the voltage generator 140, and the controller 150 of FIG. 1 may be located in the non-display area NDA of the display panel DP. In embodiments, the gate driver 120 may be located in the non-display area NDA. In this case, the data driver 130, the voltage generator 140, and the controller 150 may be implemented as the driver integrated circuit DIC of FIG. 1 that is separated from the display panel DP. The driver integrated circuit DIC may be connected to the lines located in the non-display area NDA. In other embodiments, the gate driver 120 along with the data driver 130, the voltage generator 140, and the controller 150 may be implemented as a single integrated circuit that is separate from the display panel DP.

In embodiments, the display area DA may have various shapes. The display area DA may have a closed-loop shape, including linear and/or curved sides. For example, the display area DA may have shapes, such as a polygon, a circle, a semicircle, and an ellipse.

In embodiments, the display panel DP may have a planar display surface. In embodiments, the display panel DP may have a display surface that is at least partially rounded. In embodiments, the display panel DP may be bendable, foldable, or rollable. In the aforementioned cases, the display panel DP and/or a substrate of the display panel DP may include materials having flexible properties.

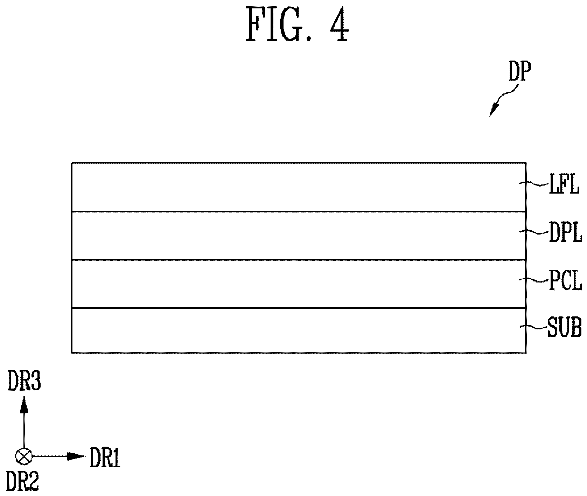

FIG. 4 is a sectional view illustrating the display panel DP in accordance with one or more embodiments.

Referring to FIG. 4, the display panel DP may include a substrate SUB, and a pixel circuit layer PCL, a display element layer DPL, and a light functional layer LFL that are sequentially stacked on the substrate SUB in a third direction DR3 crossing the first and second directions DR1 and DR2.

The substrate SUB may be made of insulating material, such as glass or resin. For example, the substrate SUB may include a glass substrate. As another example, the substrate SUB may include a polyimide (PI) substrate. As another example, the substrate SUB may include a silicon wafer substrate formed through a semiconductor process.

In embodiments, the substrate SUB may be made of material having flexibility so as to be bendable or foldable, and may have a single-layer structure or a multilayer structure. For instance, the material having flexibility may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, or cellulose acetate propionate. However, the embodiments are not limited thereto.

The pixel circuit layer PCL may be located on the substrate SUB. The pixel circuit layer PCL may include insulating layers, and semiconductor patterns and conductive patterns located between the insulating layers. The conductive patterns of the pixel circuit layer PCL may function as circuit elements, lines, or the like.

The circuit elements of the pixel circuit layer PCL may include the respective sub-pixel circuits SPC (refer to FIG. 2) of the sub-pixels SP of FIG. 3. In other words, the circuit elements of the pixel circuit layer PCL may be provided as transistors and one or more capacitors of the sub-pixel circuit SPC.

The lines of the pixel circuit layer PCL may include lines connected to the sub-pixels SP. The lines of the pixel circuit layer PCL may include various signal lines and/or voltage lines suitable for driving the display element layer DPL.

The display element layer DPL may be located on the pixel circuit layer PCL. The display element layer DPL may include light-emitting elements of the sub-pixels SP.

The light functional layer LFL may be located on the display element layer DPL. The light functional layer LFL may include light conversion patterns having color conversion particles and/or scattering particles. For example, the color conversion particles may include quantum dots. The quantum dots may convert the wavelength (or color) of light emitted from the display element layer DPL. The light functional layer LFL may further include light-scattering patterns having scattering particles. In embodiments, the light conversion patterns and the light-scattering patterns may be omitted.

The light functional layer LFL may further include a color filter layer including color filters. Each of the color filters may selectively transmit light of a corresponding wavelength (or corresponding color). In embodiments, the color filter layer may be omitted.

A window may be provided on the light functional layer LFL to protect an exposed surface (or upper surface) of the display panel DP. The window may protect the display panel DP from an external impact. The window may be connected to the light functional layer LFL by an optically transparent adhesive (or bonding) agent. The window WD may have a multilayer structure selected from among a glass substrate, a plastic film, and a plastic substrate. The multilayer structure may be formed through a successive process or an adhesion process using an adhesive layer. The entirety or portion of the window may have flexibility.

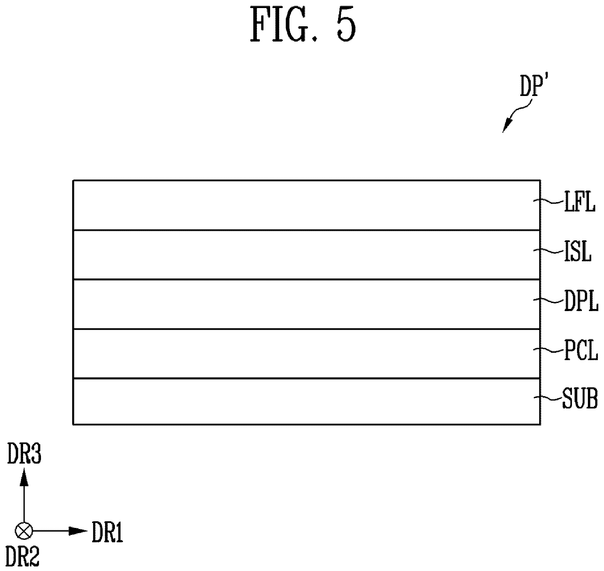

FIG. 5 is a sectional view illustrating a display panel DP' in accordance with one or more embodiments.

Referring to FIG. 5, the display panel DP' may include a substrate SUB, a pixel circuit layer PCL, a display element layer DPL, an input-sensing layer ISL, and a light functional layer LFL. The substrate SUB, the pixel circuit layer PCL, the display element layer DPL, and the light functional layer LFL may be configured in the same manner as the substrate SUB, the pixel circuit layer PCL, the display element layer DPL, and the light functional layer LFL that have been described with reference to FIG. 4. Hereinafter, repetitive explanations will be omitted.

The input-sensing layer ISL may sense a user input on an upper surface (or display surface) of the display panel DP'. The input-sensing layer ISL may include components suitable for sensing an external object, such as the hand of the user, a pen, or the like. For example, the input-sensing layer ISL may include touch electrodes.

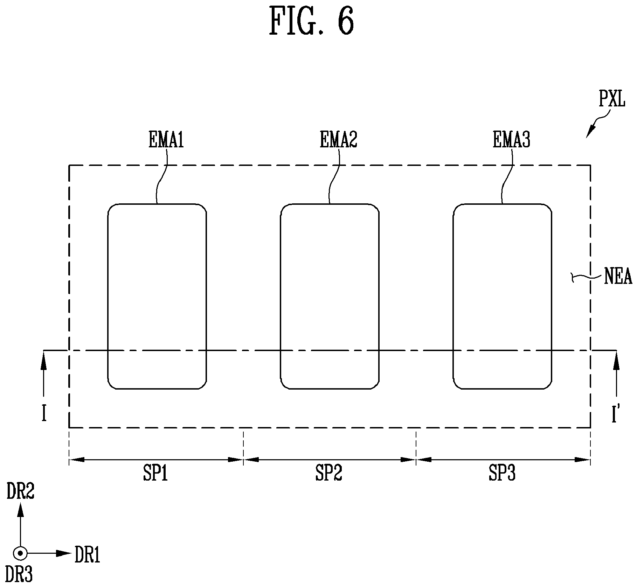

FIG. 6 is a plan view illustrating a pixel PXL in accordance with one or more embodiments.

Referring to FIG. 6, the pixel PXL may include first to third sub-pixels SP1 to SP3 arranged in the first direction DR1.

The first sub-pixel SP1 may include a first emission area EMA1, and a non-emission area NEA formed around the first emission area EMA1. The second sub-pixel SP2 may include a second emission area EMA2, and a non-emission area NEA formed around the second emission area EMA2. The third sub-pixel SP3 may include a third emission area EMA3, and a non-emission area NEA formed around the third emission area EMA3.

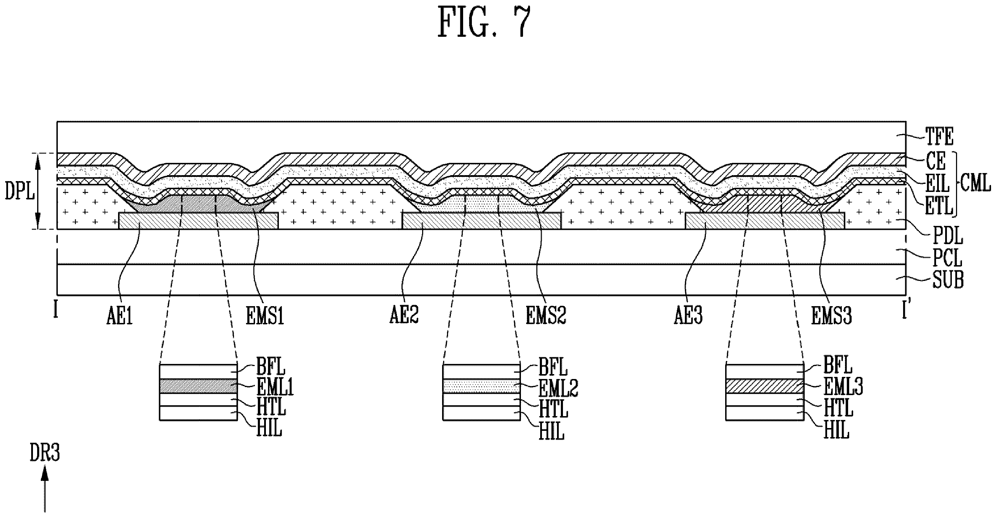

The first emission area EMA1 may be an area where light is emitted from a portion of the first emission structure EMS1 (refer to FIG. 7) that corresponds to the first sub-pixel SP1. The second emission area EMA2 may be an area where light is emitted from a portion of the second emission structure EMS2 (refer to FIG. 7) that corresponds to the second sub-pixel SP2. The third emission area EMA3 may be an area where light is emitted from a portion of the third emission structure EMS3 (refer to FIG. 7) that corresponds to the third sub-pixel SP3.

FIG. 7 is a sectional view taken along the line I-I' of FIG. 6 in accordance with one or more embodiments.

Referring to FIG. 7, the pixel circuit layer PCL is located on the substrate SUB. The pixel circuit layer PCL may include insulating layers, semiconductor patterns, and conductive patterns that are stacked on the substrate SUB. The insulating layers may include a buffer layer, one or more interlayer insulating layers, and one or more passivation layers. The semiconductor patterns and the conductive patterns may be positioned between the insulating layers. The conductive patterns may function as at least some of the circuit elements, lines, or the like. The conductive patterns may include at least one of copper (Cu), molybdenum (Mo), tungsten (W), aluminum-neodymium (AINd), titanium (Ti), aluminum (Al), or silver (Ag), but embodiments are not limited thereto.

The circuit elements may include respective sub-pixel circuits SPC (refer to FIG. 2) of the first to third sub-pixels SP1, SP2, and SP3 (refer to FIG. 6). The sub-pixel circuit SPC may include transistors and one or more capacitors. Each transistor may include a semiconductor portion including a source area, a drain area, and a channel area, and a gate electrode overlapping the semiconductor portion. In embodiments, in the case where the substrate SUB is formed of a silicon substrate, the semiconductor portion may be included in the substrate SUB, and the gate electrode may be included in the pixel circuit layer PCL as a conductive pattern of the pixel circuit layer PCL. In one or more embodiments, in the case where the substrate SUB is formed of a glass substrate or a PI substrate, the semiconductor portion and the gate electrode may be included in the pixel circuit layer PCL. Each capacitor may include electrodes spaced apart from each other. For example, each capacitor may include electrodes spaced apart from each other in the third direction DR3 with an insulating layer interposed therebetween.

The lines of the pixel circuit layer PCL may include signal lines connected to each of the first to third sub-pixels SP1 to SP3, for example, a gate line, an emission control line, and/or a data line. The lines may further include a line connected to the first power voltage node VDDN of FIG. 2. Furthermore, the lines may further include a line connected to the second power voltage node VSSN of FIG. 2.

In embodiments, a via layer may be located on the pixel circuit layer PCL. The via layer may cover the pixel circuit layer PCL, and may have an overall even surface. The via layer may include at least one of silicon oxide (SiOₓ), silicon nitride (SiNₓ), or silicon carbon nitride (SiCN), but embodiments are not limited thereto.

The display element layer DPL may be located on the pixel circuit layer PCL. The display element layer DPL may include first to third anodes AE1 to AE3, a pixel-defining layer PDL, first to third emission structures EMS1 to EMS3, and a common layer CML.

The first to third anodes AE1 to AE3 may be located on the pixel circuit layer PCL. The first to third anodes AE1 to AE3 may be spaced apart from each other. For example, the first to third anodes AE1 to AE3 may be respectively located in the first to third sub-pixels SP1 to SP3 (refer to FIG. 6). The first anode AE1 may be provided as the anode AE (refer to FIG. 2) included in the sub-pixel circuit SPC (refer to FIG. 2) of the first sub-pixel SP1. The second anode AE2 may be provided as the anode AE included in the sub-pixel circuit SPC of the second sub-pixel SP2. The third anode AE3 may be provided as the anode AE included in the sub-pixel circuit SPC of the third sub-pixel SP3.

The first to third anodes AE1 to AE3 may include at least one of transparent conductive materials, such as indium tin oxide (ITO), indium zinc oxide (IZO), zinc oxide (ZnO), indium gallium zinc oxide (IGZO), or indium tin zinc oxide (ITZO). However, the embodiments are not limited to the aforementioned example. For example, the first to third anodes AE1 to AE3 may include titanium nitride (TiN).

The pixel-defining layer PDL may be located on the pixel circuit layer PCL. The pixel-defining layer PDL may overlap portions of the first to third anodes AE1 to AE3. For example, the pixel-defining layer PDL may overlap edge portions of the first to third anodes AE1 to AE3. For example, the pixel-defining layer PDL may be directly located on portions of the first to third anodes AE1 to AE3. The pixel-defining layer PDL may include openings through which respective portions of the first to third anodes AE1 to AE3 are exposed. The openings in the pixel-defining layer PDL may define the respective emission areas of the first to third sub-pixels SP1 to SP3. In other words, the pixel-defining layer PDL may be placed in the non-emission area NEA (refer to FIG. 6), and may define the first to third emission areas EMA1 to EMA3 (refer to FIG. 6), in particular by the openings through which respective portions of the first to third anodes AE1 to AE3 are exposed.

The pixel-defining layer PDL may include a plurality of inorganic insulating layers. Each of the inorganic insulating layers may include at least one of silicon oxide (SiOₓ) or silicon nitride (SiNₓ). For example, the pixel-defining layer PDL may include first to third inorganic insulating layers that are successively stacked. The first to third inorganic insulating layers may respectively include silicon nitride, silicon oxide, and silicon nitride. However, the embodiments are not limited thereto.

The first to third emission structures EMS1 to EMS3 may be respectively located on the first to third anodes AE1 to AE3. In other words, the first emission structure EMS1 may be located on the first anode AE1, the second emission structure EMS2 may be located on the second anode AE2 and the third emission structure EMS3 may be located on the third anode AE3. For example, the first to third emission structures EMS1 to EMS3 may be respectively located on the first to third anodes AE1 to AE3 that are exposed through the openings of the pixel-defining layer PDL. The first to third emission structures EMS1 to EMS3 may overlap portions of the pixel-defining layer PDL. For example, the first to third emission structures EMS1 to EMS3 may be directly located on portions of the pixel-defining layer PDL.

An edge of each of the first to third emission structures EMS1 to EMS3 may be gently curved. For example, the edge of each of the first to third emission structures EMS1 to EMS3 may not have a steep step. For example, the edge of each of the first to third emission structures EMS1 to EMS3 may have a gentle slope on the pixel-defining layer PDL. For example, the edge of each of the first to third emission structures EMS1 to EMS3 may have an inverted tapered structure (or shape). In this case, a width (or diameter) of each of the first to third emission structures EMS1 to EMS3 may increase in the third direction DR3 (or a thickness direction).

In other words, the edge of each of the first to third emission structures EMS1 to EMS3 may be inclined with respect to a thickness direction, in particular DR3, of the display device. In particular, these inclined edges may be side edges of the first to third emission structures EMS1 to EMS3 which may be in contact with the pixel-defining layer PDL.

If the edge of each of the first to third emission structures EMS1 to EMS3 has a steep (e.g., nearly vertical) step, the structure(s) located on the first to third emission structures EMS1 to EMS3 may be disconnected. For example, the cathode CE may be disconnected by the steep step, thus making a contact structure unstable. A separate structure, such as a spacer may be introduced to remove the steep step, although a fabrication process may be more complicated, and fabrication costs may increase. If the edge of each of the first to third emission structures EMS1 to EMS3 is gently curved, the likelihood of disconnection of the cathode CE may be reduced or readily prevented, and a stable contact structure may be secured.

The first emission structure EMS1 may include a hole injection layer HIL, a hole transport layer HTL, a first emission layer EML1, and a buffer layer BFL. The hole injection layer HIL of the first emission structure EMS1 may be located on the first anode AE1. The hole transport layer HTL of the first emission structure EMS1 may be located on the hole injection layer HIL of the first emission structure EMS1. The first emission layer EML1 may be located on the hole transport layer HTL of the first emission structure EMS1. In embodiments, the first emission layer EML1 may emit light in red color. The buffer layer BFL of the first emission structure EMS1 may be located on the first emission layer EML1. The buffer layer BFL of the first emission structure EMS1 may protect the first emission layer EML1. For example, the buffer layer BFL of the first emission structure EMS1 may reduce or prevent foreign substances, such as oxygen or water, penetrating into the first emission structure EML1. The buffer layer BFL may include inorganic material, such as silicon carbon nitride, but embodiments are not limited thereto.

The second emission structure EMS2 may include a hole injection layer HIL, a hole transport layer HTL, a second emission layer EML2, and a buffer layer BFL. The hole injection layer HIL of the second emission structure EMS2 may be located on the second anode AE2. The hole transport layer HTL of the second emission structure EMS2 may be located on the hole injection layer HIL of the second emission structure EMS2. The second emission layer EML2 may be located on the hole transport layer HTL of the second emission structure EMS2. In embodiments, the second emission layer EML2 may emit light in green color. The buffer layer BFL of the second emission structure EMS2 may be located on the second emission layer EML2. The buffer layer BFL of the second emission structure EMS2 may protect the second emission layer EML2. For example, the buffer layer BFL of the second emission structure EMS2 may reduce or prevent foreign substances, such as oxygen or water, penetrating into the second emission structure EML2.

The third emission structure EMS3 may include a hole injection layer HIL, a hole transport layer HTL, a third emission layer EML3, and a buffer layer BFL. The hole injection layer HIL of the third emission structure EMS3 may be located on the third anode AE3. The hole transport layer HTL of the third emission structure EMS3 may be located on the hole injection layer HIL of the third emission structure EMS3. The third emission layer EML3 may be located on the hole transport layer HTL of the third emission structure EMS3. In embodiments, the third emission layer EML3 may emit light in blue color. The buffer layer BFL of the third emission structure EMS3 may be located on the third emission layer EML3. The buffer layer BFL of the third emission structure EMS3 may protect the third emission layer EML3. For example, the buffer layer BFL of the third emission structure EMS3 may reduce or prevent foreign substances, such as oxygen or water, penetrating into the third emission structure EML3.

The first to third emission layers EML1 to EML3 may each include an organic light-emitting material, but embodiments are not limited thereto. For example, the first to third emission layers EML1 to EML3 may each include an inorganic light-emitting material, a quantum dot, a quantum rod, etc.

In embodiments, the first to third emission structures EMS1 to EMS3 may each include a material resistant to water or etchant. For example, the first to third emission structures EMS1 to EMS3 may each include a material that substantially maintains characteristics, such as driving voltage, emission efficiency, color coordinates, and lifespan of the display device DD (refer to FIG. 1) even after exposure to water (or air). For example, the first to third emission structures EMS1 to EMS3 may include a material that substantially maintains the original shapes of the first to third emission structures EMS1 to EMS3 and the aforementioned characteristics of the display device DD even after exposure to the etchant including phosphoric acid, nitric acid, and acetic acid.

The common layer CML may be located successively over the first to third sub-pixels SP1 to SP3 (refer to FIG. 6). For example, the common layer CML may be located on the first to third emission structures EMS1 to EMS3 and the pixel-defining layer PDL.

A side surface of each of the first to third emission structures EMS1 to EMS3, which may be in contact with the common layer CML, may have a waved shape. In particular, the respective side surface may include at least one recess and/or depression. These side surfaces may be upper surfaces of the first to third emission structures EMS1 to EMS3. In an exemplary embodiment, the at least one recess and/or depression may be adjoint one inclined side surface of the first to third emission structures EMS1 to EMS3, respectively. In an exemplary embodiment, the upper surface of the first to third emission structures EMS1 to EMS3 may have two recesses or depressions, wherein each recess or depression may be adjoint one side surface of the first to third emission structures EMS1 to EMS3 respectively, as can be seen in FIGS. 7 to 9 for example.

In one or more embodiments, the common layer CML may include an electron transport layer ETL, an electron injection layer EIL, and a cathode CE. The electron transport layer ETL may be located on the first to third emission structures EMS1 to EMS3 and the pixel-defining layer PDL. The electron injection layer EIL may be located on the electron transport layer ETL. The cathode CE may be located on the electron injection layer EIL. As described above, the cathode CE may be continuously located on the electron injection layer EIL without disconnection. The common layer CML may include an electron transport layer ETL and an electron injection layer EIL that are divided into separate layers, but the embodiments are not limited thereto. For example, the electron transport layer ETL and the electron injection layer EIL may be integrated into a single layer. The single layer may include a composite material in which a material of the electron transport layer ETL and a material of the electron injection layer EIL are mixed.

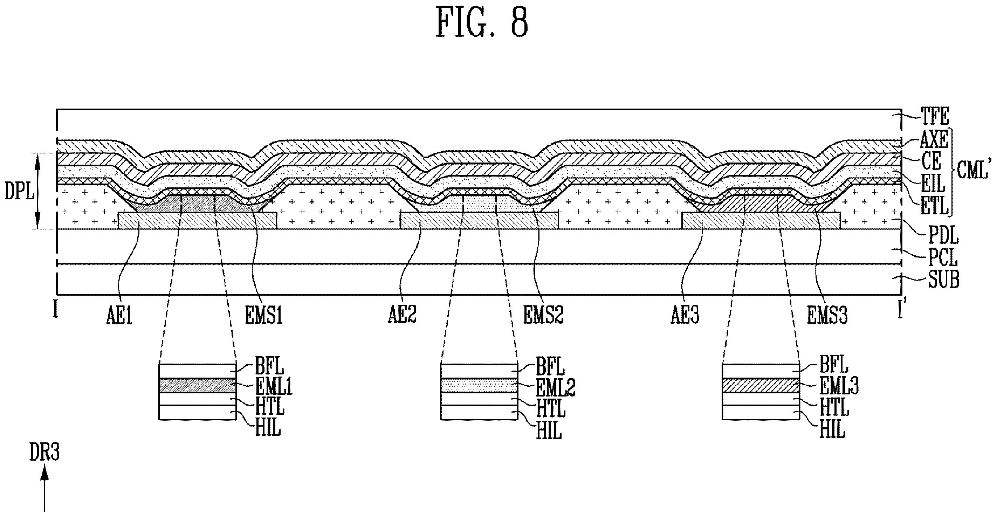

In an exemplary embodiment, the common layer CML or at least one of the layers defining the common layer CML may have or may follow the shape of the upper surface of the first to third emission structures EMS1 to EMS3, see for example FIG. 8. Thus, the common layer CML or at least one of the layers defining the common layer CML may be waved at the part above the first to third emission structures EMS1 to EMS3. In other words, the common layer CML or at least one of the layers defining the common layer CML may be located in the at least one recess or depression. Thus, if the common layer CML or at least one of the layers defining the common layer CML have a constant thickness, the common layer CML or at least one of the layers defining the common layer CML may be waved.

The encapsulation layer TFE may be located on the display element layer DPL. For example, the encapsulation layer TFE may be located on the cathode CE. The encapsulation layer TFE may reduce or prevent oxygen, water, or the like from penetrating into the light-emitting-element layer DPL. The encapsulation layer TFE may include a structure formed by alternately stacking one or more inorganic layers and one or more organic layers. For example, the inorganic layer may include, for example, silicon nitride, silicon oxide, or silicon oxynitride (SiOₓN_{y}). For example, the organic layer may include acrylic resin, epoxy resin, phenolic resin, polyamides resin, polyimides resin, unsaturated polyesters resin, polyphenylenes resin, polyphenylene sulfides resin, benzocyclobutene (BCB), or the like. However, the embodiments are not limited to the aforementioned example. For example, the encapsulation layer TFE may include aluminum oxide (AlOx).

FIG. 8 is a sectional view taken along the line I-I' of FIG. 6 in accordance with one or more embodiments. With regard to FIG. 8, the explanation of contents overlapping that of FIG. 7 is simplified or omitted.

Referring to FIG. 8, a common layer CML' may further include an auxiliary electrode AXE. The auxiliary electrode AXE may be located between the cathode CE and the encapsulation layer TFE. The auxiliary electrode AXE may contribute to forming a stable contact structure along with the cathode CE. The auxiliary electrode AXE may include a material that is different from that of the cathode CE. For example, the auxiliary electrode AXE may include a transparent conductive material, such as indium tin oxide (ITO) or indium zinc oxide (IZO). The cathode CE may include a translucent conductive material, such as silver (Ag) or a silver alloy (Ag alloy). In this case, the cathode CE may partially reflect and amplify light emitted from the first to third emission layers EML1 to EML3. The amplified light may be outputted through the cathode CE and the auxiliary electrode AXE.

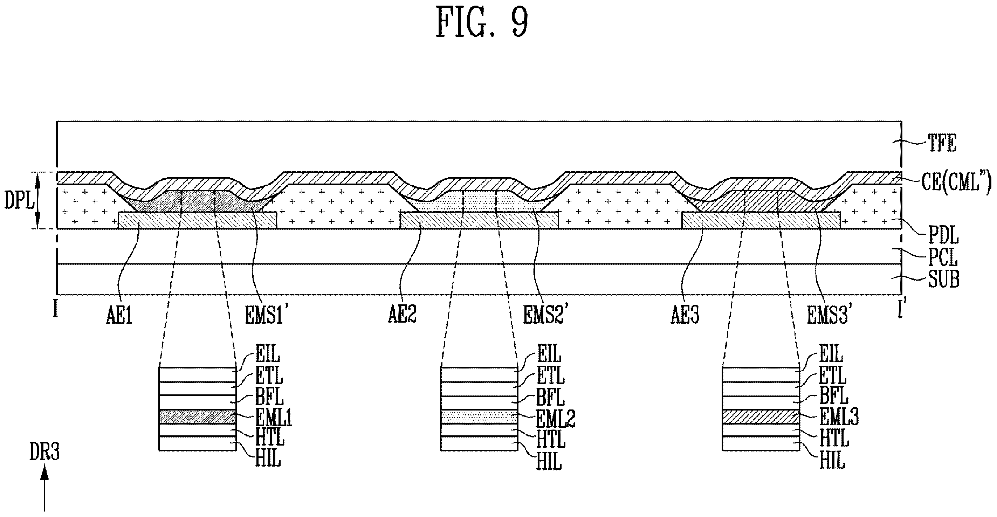

FIG. 9 is a sectional view taken along the line I-I' of FIG. 6 in accordance with one or more embodiments. With regard to FIG. 9, the explanation of contents overlapping that of FIG. 7 is simplified or omitted.

Referring to FIG. 9, first to third emission structures EMS' to EMS3' may each include an electron transport layer ETL and an electron injection layer EIL. The electron transport layer ETL may be located on the buffer layer BFL. The electron injection layer EIL may be located on the electron transport layer ETL. In this case, the common layer CML" may be substantially the same as the cathode CE.

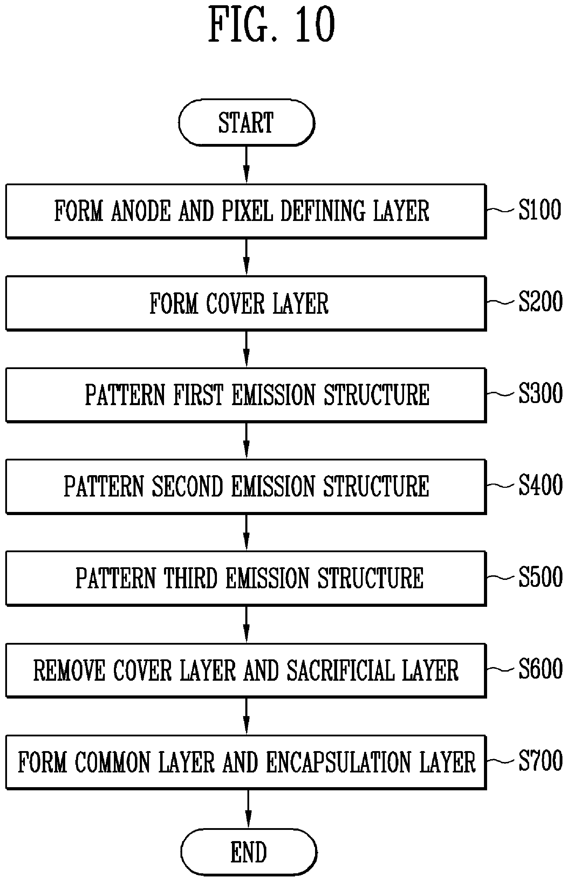

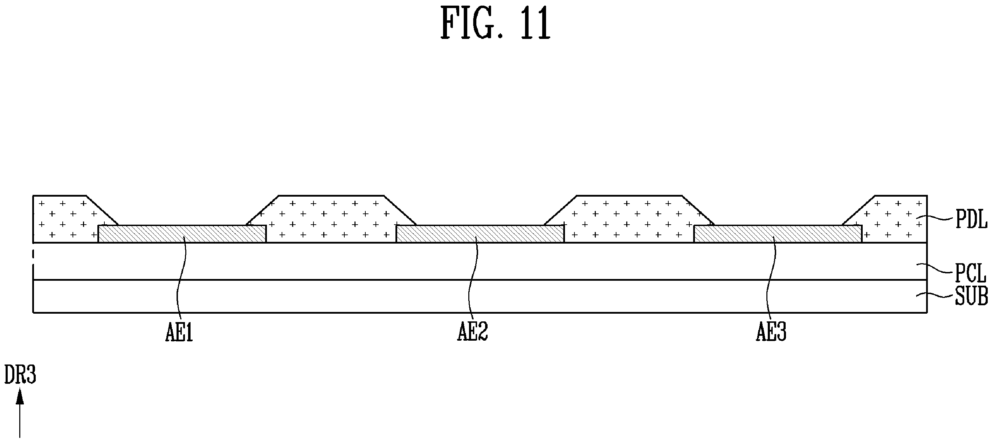

FIG. 10 is a block diagram illustrating a method of fabricating the display device in accordance with one or more embodiments. FIGS. 11 to 27 are sectional views schematically illustrating the method of fabricating the display device in accordance with embodiments. Hereinafter, the method of fabricating the display device using an indirect patterning process will be described with reference to FIGS. 10 to 27.

Referring to FIGS. 10 and 11, process S100 of forming an anode and a pixel-defining layer may be performed. The first to third anodes AE1 to AE3 spaced apart from each other may be formed on the pixel circuit layer PCL on the substrate SUB. For example, the first anode AE1 may be patterned at a position corresponding to the first emission area EMA1 (refer to FIG. 6). The second anode AE2 may be patterned at a position corresponding to the second emission area EMA2 (refer to FIG. 6). The third anode AE3 may be patterned at a position corresponding to the third emission area EMA3 (refer to FIG. 6). For example, the pixel-defining layer PDL may be formed on portions of the first to third anodes AE1 to AE3 and the pixel circuit layer PCL. For example, after the pixel-defining layer PDL is formed entirely over the first to third anodes AE1 to AE3 and the pixel circuit layer PCL, the pixel-defining layer PDL may be etched to form openings through which the first to third anodes AE1 to AE3 are exposed.

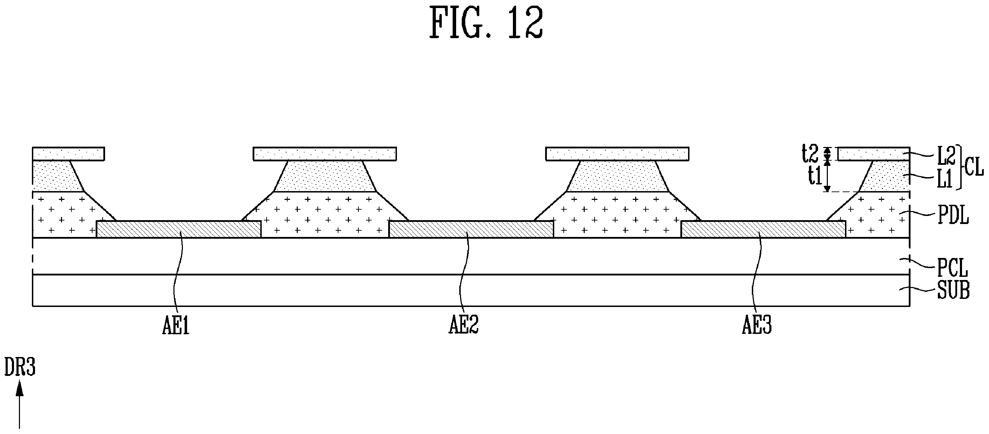

Referring to FIG. 10, process S200 of forming a cover layer may be performed. FIG. 12 illustrates the cover layer forming process S200 in accordance with one or more embodiments. Referring to FIGS. 10 and 12, the cover layer CL may be formed on the pixel-defining layer PDL through an etching process. For example, the cover layer CL having a multilayer structure may be formed on the pixel-defining layer PDL. The cover layer CL may include a first layer L1 and a second layer L2. The first layer L1 may be located on the pixel-defining layer PDL. The second layer L2 may be located on the first layer L1.

In one or more embodiments, a thicknesses t1 of the first layer L1 and a thickness t2 of the second layer L2 may differ from each other. The term "thickness" may refer to a length measured in the third direction DR3. For example, the thickness t1 of the first layer L1 may be greater than the thickness t2 of the second layer L2. For example, the thickness t1 of the first layer L1 may be about 2000 Å (angstroms), and the thickness t2 of the second layer L2 may be about 1000 Å. In one or more embodiments, the first layer L1 and the second layer L2 may be formed of different materials. For example, the first layer L1 may include a nickel aluminum alloy (AlNi alloy), and the second layer L2 may be include aluminum (Al), but the embodiments are not limited thereto.

The cover layer CL may be formed in an undercut structure. For example, a width of the second layer L2 may be greater than a width of the first layer L1. The term "width" may refer to a length measured in a direction (or a longitudinal direction) perpendicular to the third direction DR3. During an etching process, the cover layer CL having an undercut structure may be formed by adjusting selectivity with respect to the first and second layers L1 and L2. For example, an etch rate of the first layer L1 may be higher than an etch rate of the second layer L2. The cover layer CL may overlap at least a portion of an edge of each of the first to third anodes AE1 to AE3. For example, the second layer L2 of the cover layer CL may overlap at least a portion of an edge of each of the first to third anodes AE1 to AE3. The cover layer CL having an undercut structure may contribute to forming the edge of each of the first to third emission structures EMS1 to EMS3 (refer to FIG. 7) into a gently curved shape.

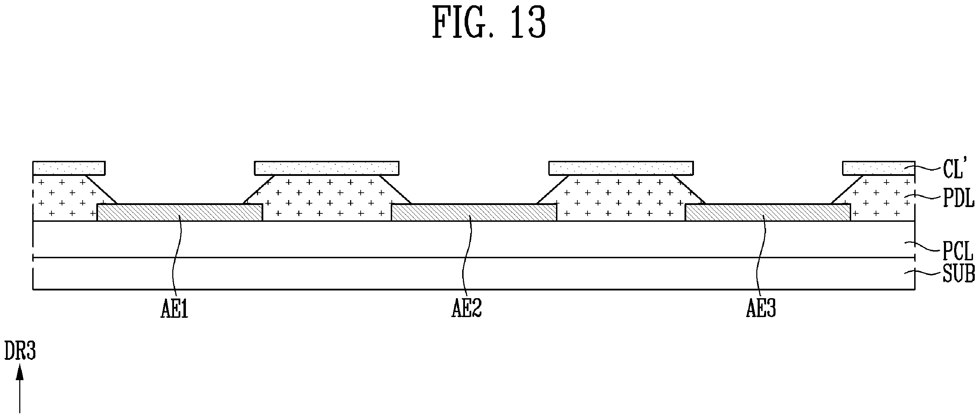

FIG. 13 illustrates a cover layer forming process S200 in accordance with one or more other embodiments. Referring to FIGS. 10 and 13, a cover layer CL' may be formed on the pixel-defining layer PDL through an etching process. The pixel-defining layer PDL may have inclined side surfaces. These inclined surfaces may correspond to the inclined surfaces of the first to third emission structure EMS1, EMS2, EMS3. For example, the cover layer CL' having a single-layer structure may be formed on the pixel-defining layer PDL. The cover layer CL' may have titanium (Ti), but the embodiments are not limited thereto. The cover layer CL' may be formed in an undercut structure. In the case where the cover layer CL' having an undercut structure is formed, the number of masks used during the fabrication process may be reduced.

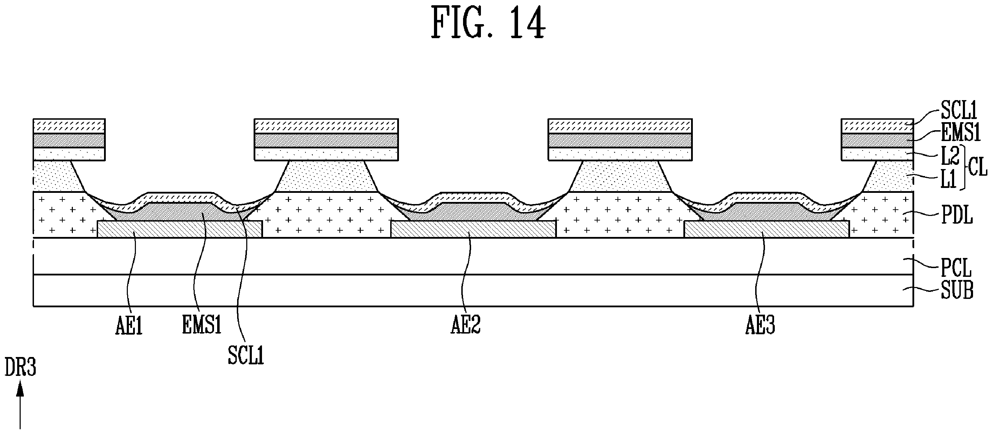

Referring to FIGS. 10 and 14 to 17, process S300 of patterning a first emission structure may be performed. Referring to FIG. 14, the first emission structure EMS1 may be formed on the first to third anodes AE1 to AE3, the pixel-defining layer PDL, and the cover layer CL (or the second layer L2). The first emission structure EMS1 on the cover layer CL may be formed to have a steep (e.g., nearly vertical) step. On the other hand, the first emission structure EMS1 on the first to third anodes AE1 to AE3 and the pixel-defining layer PDL may be formed to be gently curved. In particular, the upper surfaces of the first to third emission structure EMS1, EMS2, EMS3 may be gently curved or waved. For example, during a process of depositing the first emission structure EMS1, the cover layer CL having an undercut structure shadows or interferes with deposition materials, whereby the edge of the first emission structure EMS1 may be formed in a gently curved shape. Thereafter, a first sacrificial layer SCL1 may be formed on the first emission structure EMS1. Due to the cover layer CL having an undercut structure, the first sacrificial layer SCL1 may be partially formed on the pixel-defining layer PDL. The first sacrificial layer SCL1 may include aluminum (Al), silver (Ag), or the like, but the embodiments are not limited.

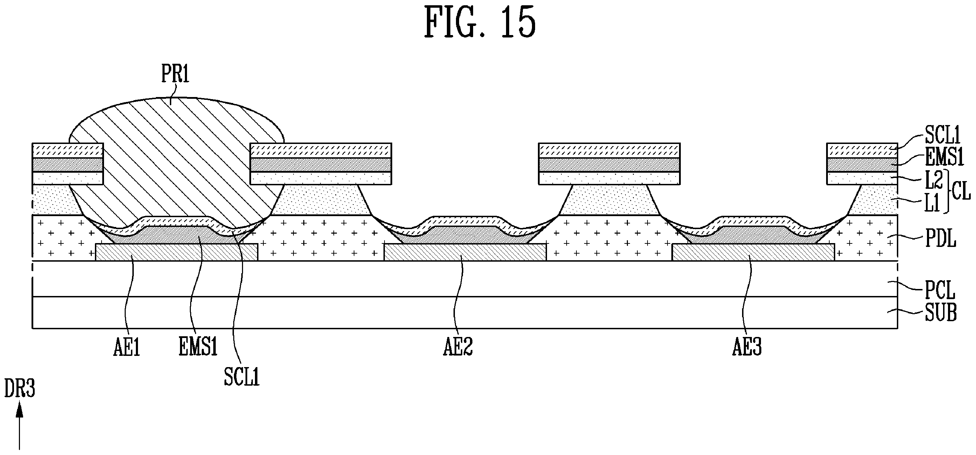

Referring to FIG. 15, a first photoresist PR1 may be formed on the first sacrificial layer SCL1. The first photoresist PR1 may be formed to cover the structures on the first anode AE1. The first photoresist PR1 may be formed through an exposure process and a development process.

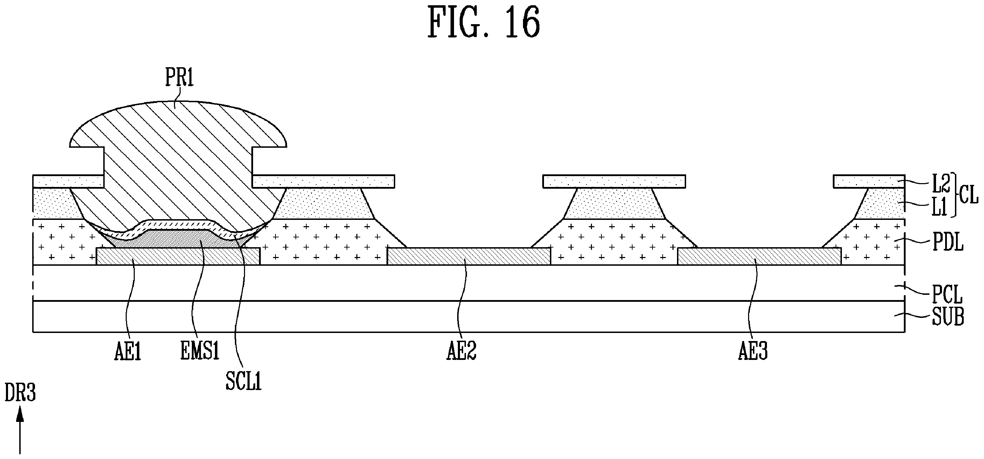

Referring to FIG. 16, the first emission structure EMS1 and the first sacrificial layer SCL1 may be partially removed. For example, the first emission structure EMS1 and the first sacrificial layer SCL1 on the second and third anodes AE2 and AE3 and the cover layer CL may be removed through an etching process. The etching process may be performed as wet etching or dry etching. Accordingly, the first emission structure EMS1 and the first sacrificial layer SCL1 on the first anode AE1 may remain.

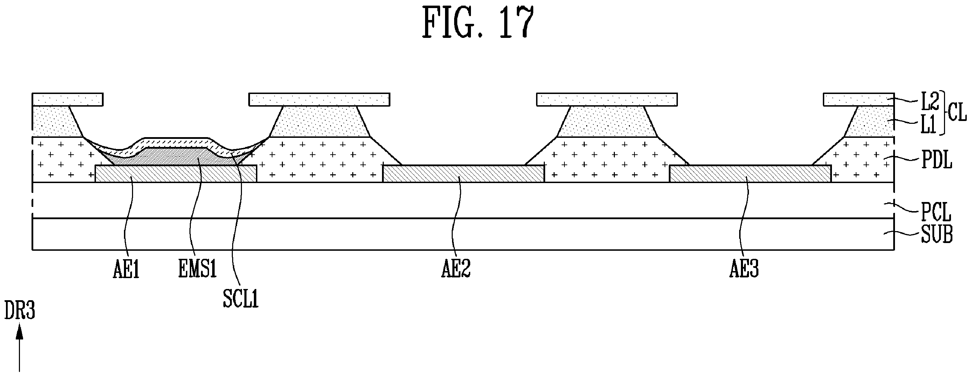

Referring to FIG. 17, the first photoresist PR1 may be removed. For example, the first photoresist PR1 may be removed through an ashing process. Accordingly, the first emission structure EMS1 may be patterned at a position corresponding to the first anode AE1. The first sacrificial layer SCL1 may be positioned on the first emission structure EMS1.

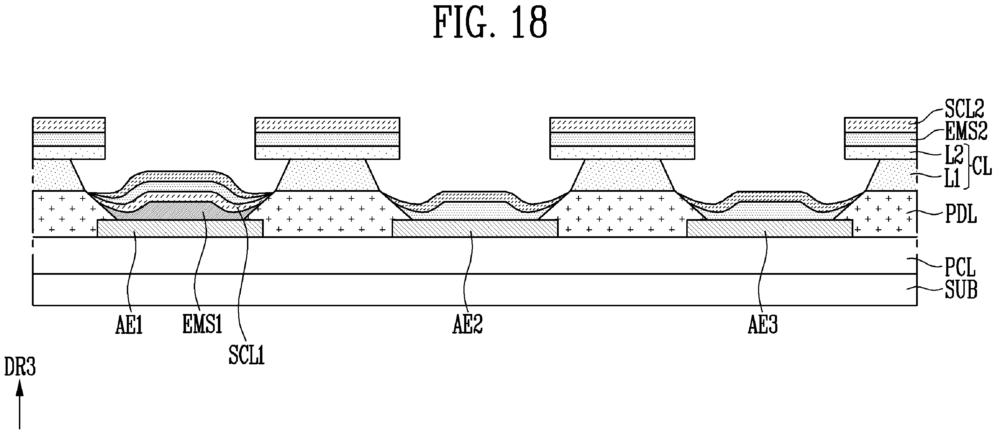

Referring to FIGS. 10 and 18 to 21, process S400 of patterning a second emission structure may be performed. Referring to FIG. 18, the second emission structure EMS2 may be formed on the second and third anodes AE2 and AE3, the first sacrificial layer SCL1, the pixel-defining layer PDL, and the cover layer CL (or the second layer L2). The second emission structure EMS2 on the cover layer CL may be formed to have a steep (e.g., nearly vertical) step. On the other hand, the second emission structure EMS2 on the second and third anodes AE2 and AE3, the first sacrificial layer SCL1, and the pixel-defining layer PDL may be formed to be gently curved. For example, during a process of depositing the second emission structure EMS2, the cover layer CL having an undercut structure shadows deposition materials, whereby the edge of the second emission structure EMS2 may be formed in a gently curved shape. Thereafter, a second sacrificial layer SCL2 may be formed on the second emission structure EMS2. Due to the cover layer CL having an undercut structure, the second sacrificial layer SCL2 may be partially formed on the pixel-defining layer PDL. The second sacrificial layer SCL2 may include the same material as the first sacrificial layer SCL1, but the embodiments are not limited thereto.

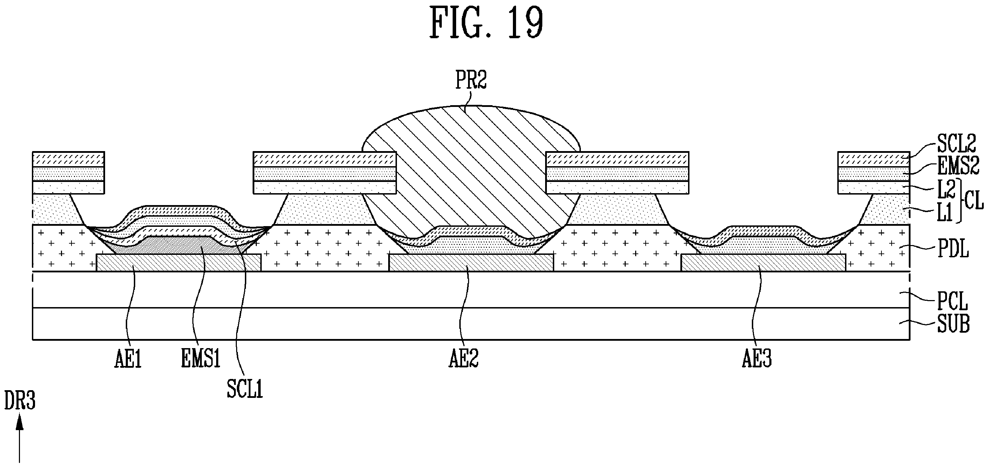

Referring to FIG. 19, a second photoresist PR2 may be formed on the second sacrificial layer SCL2. The second photoresist PR2 may be formed to cover the structures on the second anode AE2. The second photoresist PR2 may be formed through an exposure process and a development process.

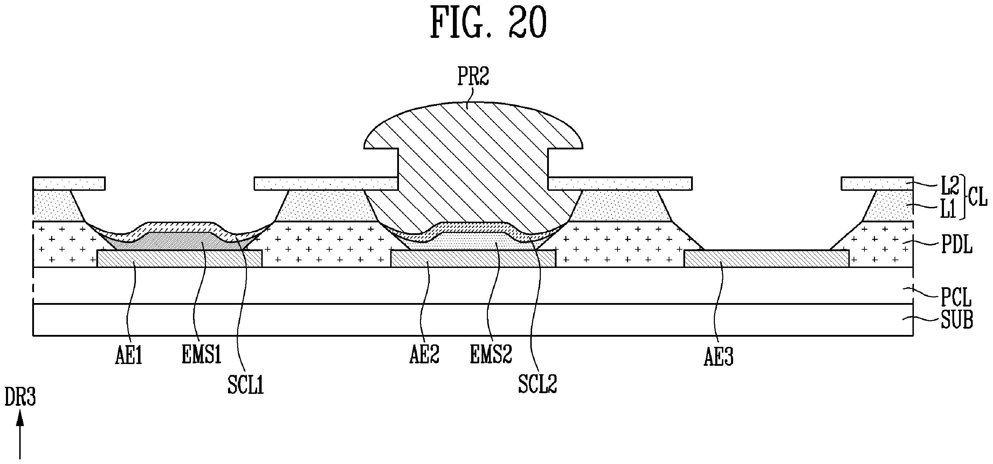

Referring to FIG. 20, the second emission structure EMS2 and the second sacrificial layer SCL2 may be partially removed. For example, the second emission structure EMS2 and the second sacrificial layer SCL2 on the first sacrificial layer SCL1, the third anode AE3, and the cover layer CL may be removed through an etching process. The etching process may be performed as wet etching or dry etching. Accordingly, the second emission structure EMS2 and the second sacrificial layer SCL2 on the second anode AE2 may remain.

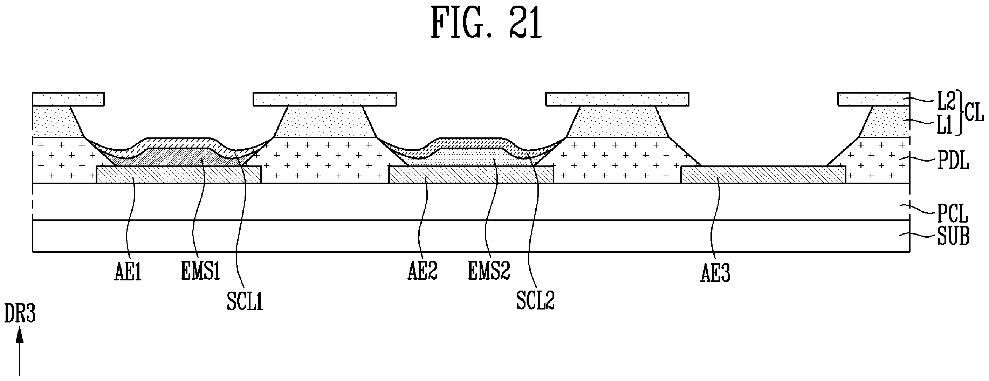

Referring to FIG. 21, the second photoresist PR2 may be removed. For example, the second photoresist PR2 may be removed through an ashing process. Accordingly, the second emission structure EMS2 may be patterned at a position corresponding to the second anode AE2. The second sacrificial layer SCL2 may be positioned on the second emission structure EMS2.

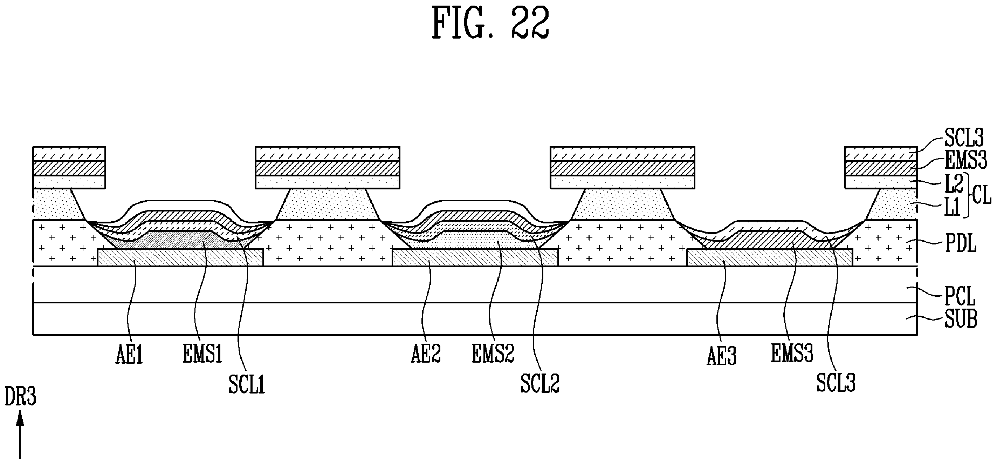

Referring to FIGS. 10 and 22 to 25, process S500 of patterning a third emission structure may be performed. Referring to FIG. 22, the third emission structure EMS3 may be formed on the third anode AE3, the first and second sacrificial layers SCL1 and SCL2, the pixel-defining layer PDL, and the cover layer CL (or the second layer L2). The third emission structure EMS3 on the cover layer CL may be formed to have a steep (e.g., nearly vertical) step. On the other hand, the third emission structure EMS3 on the third anode AE3, the first and second sacrificial layers SCL1 and SCL2, and the pixel-defining layer PDL may be formed to be gently curved. For example, during a process of depositing the third emission structure EMS3, the cover layer CL having an undercut structure shadows deposition materials, whereby the edge of the third emission structure EMS3 may be formed in a gently curved shape. Thereafter, a third sacrificial layer SCL3 may be formed on the third emission structure EMS3. Due to the cover layer CL having an undercut structure, the third sacrificial layer SCL3 may be partially formed on the pixel-defining layer PDL. The third sacrificial layer SCL3 may include the same material as the first sacrificial layer SCL1, but the embodiments are not limited thereto.

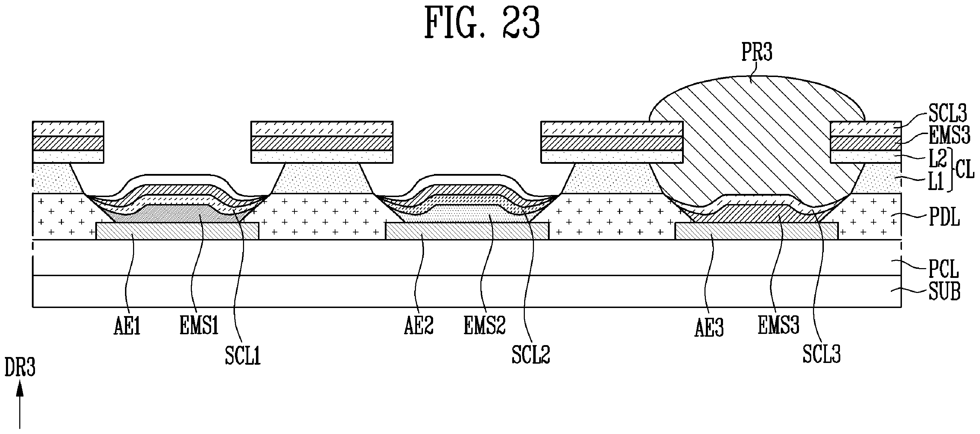

Referring to FIG. 23, a third photoresist PR3 may be formed on the third sacrificial layer SCL3. The third photoresist PR3 may be formed to cover the structures on the third anode AE3. The third photoresist PR3 may be formed through an exposure process and a development process.

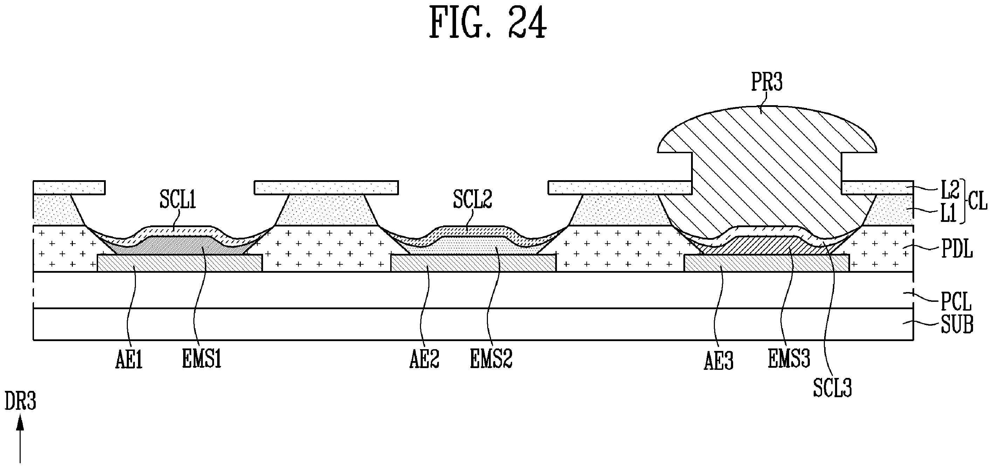

Referring to FIG. 24, the third emission structure EMS3 and the third sacrificial layer SCL3 may be partially removed. For example, the third emission structure EMS3 and the third sacrificial layer SCL3 on the first and second sacrificial layers SCL1 and SCL2 and the cover layer CL may be removed through an etching process. The etching process may be performed as wet etching or dry etching. Accordingly, the third emission structure EMS3 and the third sacrificial layer SCL3 on the third anode AE3 may remain.

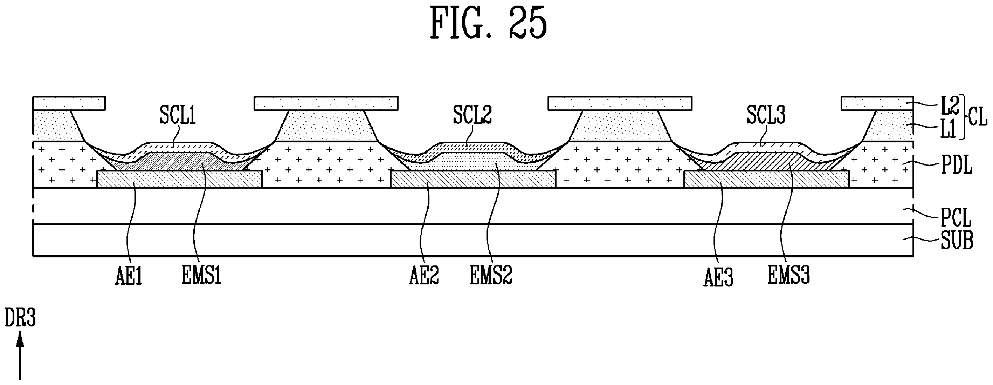

Referring to FIG. 25, the third photoresist PR3 may be removed. For example, the third photoresist PR3 may be removed through an ashing process. Accordingly, the third emission structure EMS3 may be patterned at a position corresponding to the third anode AE3. The third sacrificial layer SCL3 may be positioned on the third emission structure EMS3.

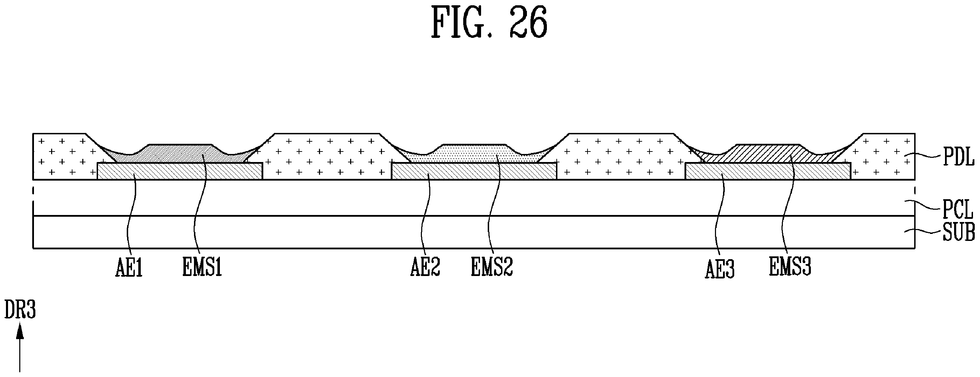

Referring to FIGS. 10 and 26, process S600 of removing the cover layer and the sacrificial layer may be performed. The cover layer CL (refer to FIG. 25) and the first to third sacrificial layers SCL1 to SCL3 (refer to FIG. 25) may be removed through an etching process. The etching process may be performed as wet etching. Accordingly, upper surfaces of the first to third emission structures EMS1 to EMS3 may be exposed. After the sacrificial layer removal process S600, a drying process may be performed to remove moisture. For example, the drying process may be performed at a temperature of about 90 °C under vacuum conditions.

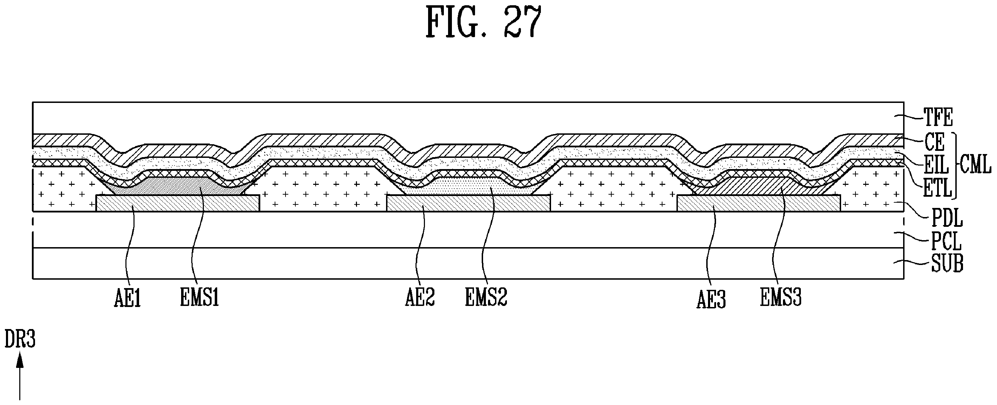

Referring to FIGS. 10 and 27, process S700 of forming a common layer and an encapsulation layer may be performed. First, the common layer CML may be formed. For example, the electron transport layer ETL may be formed on the first to third emission structures EMS1 to EMS3 and the pixel-defining layer PDL. The electron injection layer EIL may be formed on the electron transport layer ETL. Thereafter, the cathode CE may be formed on the electron injection layer EIL. In one or more embodiments, the auxiliary electrode AXE (refer to FIG. 8) may be formed on the cathode CE. Thereafter, the encapsulation layer TFE may be formed on the common layer CML.

As illustrated in FIG. 27, because the edge of each of the first to third emission structures EMS1 to EMS3 is patterned in a gently curved shape, the common layer CML (for example, the cathode CE) may be continuously formed on the first to third emission structures EMS1 to EMS3 without disconnection, and an additional structure, such as a spacer is not required.

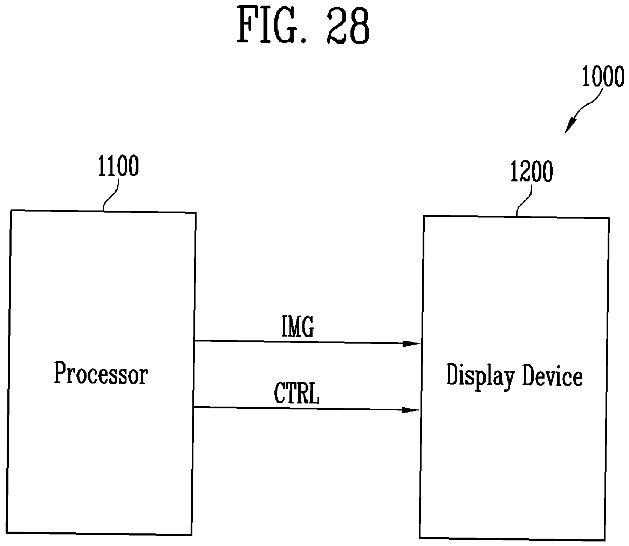

FIG. 28 is a block diagram illustrating a display system 1000 in accordance with one or more embodiments.

Referring to FIG. 28, the display system 1000 may include a processor 1100 and a display device 1200.

The processor 1100 may perform various tasks and operations. In embodiments, the processor 1100 may include an application processor, a graphic processor, a microprocessor, a central processing unit (CPU), and so on. The processor 1100 may be connected to the other components of the display system 1000 through a bus system to control the components.

The processor 1100 may transmit image data IMG and a control signal CTRL to the display device 1200. The display device 1200 may display an image based on the image data IMG and the control signal CTRL. The display device 1200 may be configured in the same manner as the display device DD described with reference to FIG. 1. In this case, the image data IMG and the control signal CTRL may be provided as the input image data IMG and the control signal CTRL of FIG. 1, respectively.

The display system 1000 may include computing systems that provide an image display function, such as a smart watch, a mobile phone, a smart phone, a portable computer, a tablet personal computer (tablet PC), a watch phone, an automotive display, smart glasses, a portable multimedia player (PMP), a navigation system, an ultra-mobile personal computer (UMPC), a television (TV), and/or a monitor. Furthermore, the display system 1000 may include at least one of a head-mounted display (HMD), a virtual reality (VR) device, a mixed reality (MR) device, or an augmented reality (AR) device.

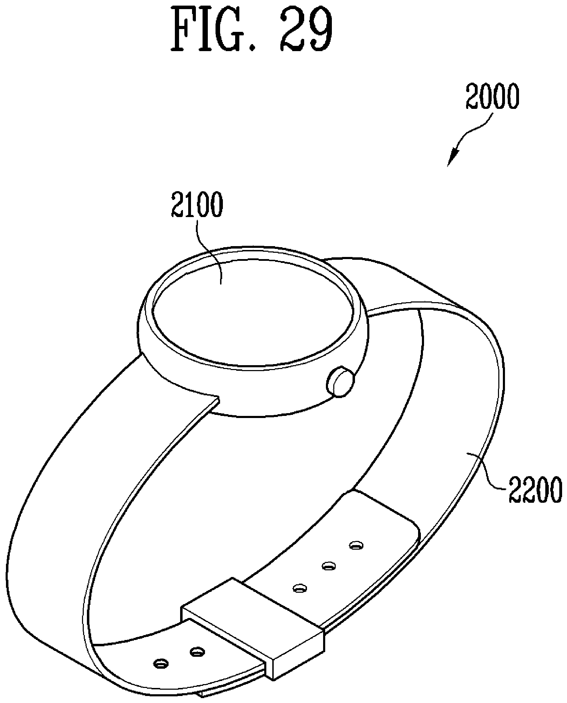

FIGS. 29 to 32 are perspective views illustrating application examples of the display system of FIG. 28.

Referring to FIG. 29, the display system 1000 of FIG. 28 may be applied to a smart watch 2000 including a display component 2100 and a strap 2200.

The smart watch 2000 may be a wearable electronic device. For example, the smart watch 2000 may have a structure in which the strap 2200 may be mounted on the wrist of the user. Here, the display system 1000 and/or the display device 1200 may be applied to the display component 2100, so that image data including time information can be provided to the user.

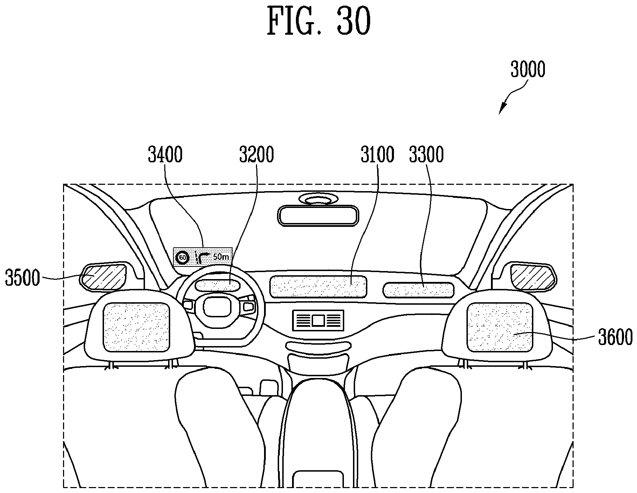

Referring to FIG. 30, the display system 1000 of FIG. 28 may be applied to the automotive display system 3000. Here, the automotive display system 3000 may include a computing system that is provided inside and/or outside a vehicle to provide image data.

For example, the display system 1000 and/or the display device 1200 may be applied to at least any one of an infotainment panel 3100, a cluster 3200, a co-driver display 3300, a head-up display 3400, a side mirror display 3500, or a rear seat display 3600, which may be provided in the vehicle.

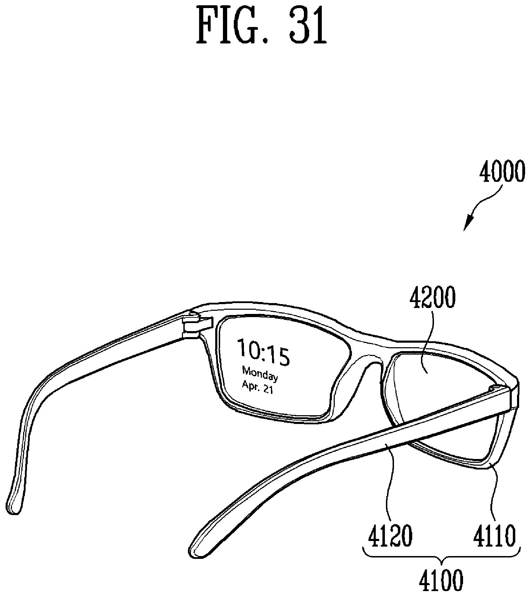

Referring to FIG. 31, the display system 1000 of FIG. 28 may be applied to smart glasses 4000. The smart glasses 4000 may be a wearable electronic device capable of being worn on the head of the user. For example, the smart glasses 4000 may be a wearable device for augmented reality.

The smart glasses 4000 may include a frame 4100 and a lens component 4200. The frame 4100 may include a housing 4110 which supports the lens component 4200, and a leg component 4120 enabling the user to wear the smart glasses. The leg component 4120 may be connected to the housing 4110 by a hinge, and thus can be folded or unfolded with respect to the housing 4110.

The frame 4100 may be equipped with a battery, a touch pad, a microphone, a camera, and the like. Furthermore, the frame 4100 may be equipped with a projector configured to output light, and a processor configured to control a light signal and the like.

The lens component 4200 may include an optical component configured to transmit or reflect light. For example, the lens component 4200 may include glass, transparent synthetic resin, and the like.

To enable the eyes of the user to perceive visual information, the lens component 4200 may reflect images based on an optical signal transmitted from the projector of the frame 4100 by a rear surface of the lens component 4200 (e.g., a surface facing the eyes of the user). For example, the user may perceive visual information, such as time and date displayed on the lens component 4200. Here, the projector and/or the lens component 4200 may be a kind of display device. The display device 1200 may be applied to the projector and/or the lens component 4200.

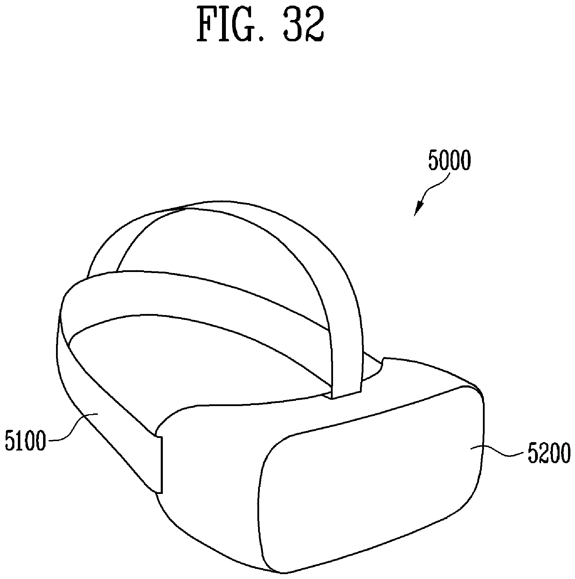

Referring to FIG. 32, the display system 1000 of FIG. 28 may be applied to a head-mounted display device 5000.

The head-mounted display device 5000 may be a wearable electronic device, which can be worn on the head of the user. For example, the head-mounted display device 5000 may be a wearable device for virtual reality or mixed reality.

The head-mounted display 5000 may include a head-mounted band 5100 and a display device reception casing 5200. The head-mounted band 5100 may be connected to the display device reception casing 5200. The head-mounted band 5100 may include a horizontal band and/or a vertical band to fasten the head-mounted display 5000 to the head of the user. The horizontal band may enclose the sides of the head of the user, and the vertical band may enclose the top of the head of the user. However, the embodiments are not limited to the aforementioned example. For example, the head-mounted band 5100 may be implemented in the form of eyeglass frames, a helmet, and so on.

The display device reception casing 5200 may receive the display system 1000 and/or the display device 1200.

The embodiments described in detail above are provided to explain the present invention, but it should be noted that the embodiments are not intended to limit the scope of the present invention. It should be understood by those skilled in the art that various changes, substitutions, and alternations may be made herein without departing from the scope of the invention as defined by the following claims.

According to some embodiments, a display device may be readily fabricated through an indirect patterning process. For example, as an edge of an emission structure is formed in a gentle curved shape, the likelihood of disconnection of a cathode may be reduced or readily prevented without introducing a separate structure for step removal.

However, aspects and features of the present invention are not limited to those described above, and various other aspects and features would be understood by one of ordinary skill in the art within the scope of the present invention.

The embodiments described in detail above are provided to explain the present invention, but these embodiments are not intended to limit the scope of the present invention. It should be understood by those skilled in the art that various changes, substitutions, and alternations may be made therein without departing from the scope of the invention as defined by the following claims.

The scope of embodiments according to the present invention is not limited by detailed descriptions of the present specification and should be defined by the accompanying claims. invention The embodiments may be combined to form additional embodiments.

## Claims

1. A display device (DD), comprising:
a substrate (SUB);
a pixel circuit layer (PCL) above the substrate (SUB);
a first anode (AE1), a second anode (AE2), and a third anode (AE3) spaced apart above the pixel circuit layer (PCL);
a pixel-defining layer (PDL) above the pixel circuit layer (PCL), and overlapping portions of the first anode (AE1), the second anode (AE2), and the third anode (AE3);
a first emission structure (EMS1), a second emission structure (EMS2), and a third emission structure (EMS3) respectively above the first anode (AE1), the second anode (AE2), and the third anode (AE3), and respectively comprising curved edges; and
a common layer (CML) above the first emission structure (EMS1), the second emission structure (EMS2), the third emission structure (EMS3), and the pixel-defining layer (PDL).

2. The display device (DD) according to claim 1, wherein the edges of the first emission structure (EMS1), the second emission structure (EMS2), and the third emission structure (EMS3) have a slope on the pixel-defining layer (PDL).

3. The display device (DD) according to claim 1 or 2, wherein the first emission structure (EMS1), the second emission structure (EMS2), and the third emission structure (EMS3) have an inverted tapered shape.

4. The display device (DD) according to at least one of claims 1 to 3, wherein widths of the first emission structure (EMS1), the second emission structure (EMS2), and the third emission structure (EMS3) increase in a thickness direction.

5. The display device (DD) according to at least one of claims 1 to 4, wherein the first emission structure (EMS1), the second emission structure (EMS2), and the third emission structure (EMS3) comprise:
a hole injection layer (HIL);
a hole transport layer (HTL) above the hole injection layer (HIL);
an emission layer (EML1, EML2) above the hole transport layer (HTL); and
a buffer layer (BFL) above the emission layer (EML1, EML2).

6. The display device (DD) according to at least one of claims 1 to 5, wherein the common layer (CML) comprises:
an electron transport layer (ETL) above the first emission structure (EMS1), the second emission structure (EMS2), the third emission structure (EMS3), and the pixel-defining layer (PDL);
an electron injection layer (EIL) above the electron transport layer (ETL); and
a cathode (CE) above the electron injection layer (EIL).

7. The display device (DD) according to at least one of claims 1 to 6, wherein the common layer (CML) further comprises an auxiliary electrode (AXE) above the cathode (CE).

8. The display device (DD) according to claim 6 or 7, wherein the cathode (CE) and the auxiliary electrode (AXE) comprise different materials.

9. The display device (DD) according to at least one of claims 6 to 8, wherein the cathode (CE) comprises a translucent conductive material, and
wherein the auxiliary electrode (AXE) comprises a transparent conductive material.

10. The display device (DD) according to at least one of claims 1 to 4, wherein the first emission structure (EMS1), the second emission structure (EMS2), and the third emission structure (EMS3) comprise:
a hole injection layer (HIL);
a hole transport layer (HTL) above the hole injection layer (HIL);
an emission layer (EML1, EML2) above the hole transport layer (HTL);
a buffer layer (BFL) above the emission layer (EML1, EML2);
an electron transport layer (ETL) above the buffer layer (BFL); and
an electron injection layer (EIL) above the electron transport layer (ETL).

11. The display device (DD) according to claim 10, wherein the common layer (CML) comprises a cathode (CE) above the first emission structure (EMS1), the second emission structure (EMS2), the third emission structure (EMS3), and the pixel-defining layer (PDL).

12. The display device (DD) according to at least one of claims 1 to 11, further comprising an encapsulation layer (TFE) above the common layer (CML).

13. A method of fabricating a display device, in particular a display device (DD) of at least one of claims 1 to 12, the method comprising:
forming a first anode (AE1), a second anode (AE2), a third anode (AE3), and a pixel-defining layer (PDL) above a pixel circuit layer (PCL) above a substrate (SUB);
forming a cover layer (CL) above a portion of the pixel-defining layer (PDL);
forming a first emission structure (EMS1) above the first anode (AE1), the second anode (AE2), the third anode (AE3), the pixel-defining layer (PDL), and the cover layer (CL);
forming a first sacrificial layer (SCL1) above the first emission structure (EMS1);
forming a first photoresist (PR1) above a portion of the first sacrificial layer (SCL1);
removing the first emission structure (EMS1) and the first sacrificial layer (SCL1) above the second anode (AE2), the third anode (AE3), and the cover layer (CL); and
removing the first photoresist (PR1).

14. The method according to claim 13, wherein the cover layer (CL) comprises:
a first layer (L1) having a first thickness; and
a second layer (L2) above the first layer (L1), and having a second thickness that is less than the first thickness.

15. The method according to claim 13 or 14, wherein a width of the second layer (L2) is greater than a width of the first layer (L1).

16. The method according to at least one of claims 13 to 15, wherein the second layer (L2) overlaps edges of the first anode (AE1), the second anode (AE2), and the third anode (AE3).

17. The method according to at least one of claims 13 to 16, further comprising:
forming a second emission structure (EMS2) above the first sacrificial layer (SCL1), the second anode (AE2), the third anode (AE3), the pixel-defining layer (PDL), and the cover layer (CL);
forming a second sacrificial layer (SCL2) above the second emission structure (EMS2);
forming a second photoresist (PR2) above a portion of the second sacrificial layer (SCL2);
removing the second emission structure (EMS2) and the second sacrificial layer (SCL2) above the first sacrificial layer (SCL1), the third anode (AE3), and the cover layer (CL); and
removing the second photoresist (PR2).

18. The method according to at least one of claims 13 to 17, further comprising:
forming a third emission structure (EMS3) above the first sacrificial layer (SCL1), the second sacrificial layer (SCL2), the third anode (AE3), the pixel-defining layer (PDL), and the cover layer (CL);
forming a third sacrificial layer (SCL3) above the third emission structure (EMS3);
forming a third photoresist (PR3) above a portion of the third sacrificial layer (SCL3);
removing the third emission structure (EMS3) and the third sacrificial layer (SCL3) above the first sacrificial layer (SCL1), the second sacrificial layer (SCL2), and the cover layer (CL); and
removing the third photoresist (PR3).

19. The method according to at least one of claims 13 to 18, further comprising removing the first to the third sacrificial layers (SCL1, SCl2, SCL3) and the cover layer (CL).

20. The method according to at least one of claims 13 to 19, further comprising:
forming a common layer (CML) above the first emission structure (EMS1), the second emission structure (EMS2), the third emission structure (EMS3), and the pixel-defining layer (PDL); and
forming an encapsulation layer (TFE) above the common layer (CML).
